# EUROPÄISCHE PATENTSCHRIFT

(11) **EP 0 300 326 B1**
(45) Veröffentlichungstag und Bekanntmachung des Hinweises auf die Patenterteilung: **16.06.1993**
(21) Anmeldenummer: 88111088.6
(22) Anmeldetag: 12.07.1988
(51) Int. Cl.: C08G 73/10, G03F 7/016, G03F 7/022

(54) **Hydroxypolyimide und daraus hergestellte hochtemperaturbeständige Positivphotoresists**
Hydroxypolyimides and high temperature resistant positive photoresists
Hydroxypolyimides et photorésists positifs résistant à la température préparés à partir de ceux-ci

(30) Priorität: 21.07.1987 US 76098
(43) Veröffentlichungstag der Anmeldung: 25.01.1989
(73) Patentinhaber: HOECHST CELANESE CORPORATION, Somerville, N.J. 08876 (US)
(72) Erfinder: Khanna, Dinesh N., West Warwick, RI 02893 (US); Müller, Werner H., Dr., East Greenwich, RI 02818 (US)
(74) Vertreter: Neubauer, Hans-Joachim

(56) Entgegenhaltungen:
- EP-A- 92 524
- CHEMICAL ABSTRACTS, Band 68, Nr. 16, 15. April 1968, Seite 6720, Zusammenfassung Nr. 69434r, Columbus, Ohio, US; V.V. KORSHAK et al.: "Synthesis of aromatic polyimides containing hydroxyl groups", & Izv. Akad. Nauk SSSR. Ser. Khim. 1968(1), 226

## Beschreibung

Die vorliegende Erfindung betrifft neue Hydroxypolyimide und damit hergestellte wäßrig-alkalisch entwickelbare, hochtemperaturbeständige, positivarbeitende Photoresistgemische.

Positivresistgemische und deren Verwendung sind bekannt. Sie werden im allgemeinen aus alkalilöslichen Phenolformaldehyd-Novolaken und licht- bzw. strahlungsempfindlichen 1,2-Chinondiaziden hergestellt. Solche Positivresists sind z.B. in den US-A-3,666,473, 4,115,128 und 4,173,470 beschrieben.

Die herkömmlichen Positivresists auf der Basis von Novolaken haben eine begrenzte Dimensionsstabilität bei hoher Temperatur und eignen sich deshalb nicht gut für die Anwendung in modernen Hochtemperaturverfahren. Hitzebeständige Negativresists sind aus den US-A-3,957,512; 4,045,223; 4,088,489, der US-B-30,186 (Reissue) und aus der DE-A-34 11 659 bekannt. In den US-A-4,093,461; 4,339,521 und 4,395,482 werden hitzebeständige Positivresists beschrieben. Man kennt auch die Vorteile der Positivresists gegenüber den Negativresists, z.B. die höhere Auflösung und die Belichtungszeitkonstanz in Gegenwart von Sauerstoff.

Die durch Belichten und Enwickeln der Photoresistschicht erzeugte Reliefstruktur eignet sich für verschiedene Verwendungszwecke, beispielsweise als Belichtungsmaske oder Schablone, wie sie bei der Herstellung von miniaturisierten integrierten elektronischen Bauteilen oder bei der Druckplattenherstellung eingesetzt wird.

Zu den für die praktische Anwendung eines Resistgemischs wichtigen Eigenschaften zählen z.B. die Löslichkeit des Resists in dem für das Beschichten verwendeten Lösemittel, die Lichtempfindlichkeit des Resists, der Entwicklungskontrast, die Löslichkeit in einem umweltfreundlichen Enwickler, das Auflösungsvermögen, die Resisthaftung, die Dimensionsstabilität bei hohen Temperaturen und die Abriebfestigkeit.

Die Lichtempfindlichkeit ist wichtig für einen Photoresist, insbesondere dort, wo mehrere Belichtungen erforderlich sind, z.B. wenn mehrfach nebeneinander mit der gleichen Vorlage belichtet wird, oder wo Licht mit verminderter Intensität verwendet wird, z.B. bei der Projektionsbelichtung. Eine richtig bemessene Lichtempfindlichkeit ist für die Herstellung von hochaufgelösten Reliefstrukturen in der Mikroschaltungstechnik von größter Bedeutung; eine zu hohe Lichtempfindlichkeit kann zum Beispiel zu einer Einengung des Verarbeitungsspielraums führen.

Der Begriff Auflösungsgrad bzw. Auflösungsvermögen bezieht sich auf die Fähigkeit eines Resists, die kleinsten, in gleichen Abständen voneinander angeordneten Linienpaare und dazwischenliegenden Gräben einer bei der Belichtung verwendeten Maske mit einem hohen Maß an Flankensteilheit in den entwickelten, freigelegten Gräben wiederzugeben. Bei vielen technischen Anwendungen, insbesondere bei der Herstellung von miniaturisierten elektronischen Bauelementen, muß ein Resist einen hohen Auflösungsgrad (in der Größenordnung von etwa 1 µm) aufweisen.

Die Fähigkeit eines Resists zur Wiedergabe solch kleiner Abmessungen ist äußerst wichtig bei der Herstellung von LSI-Schaltungen auf Siliciumchips und ähnlichen Bauelementen.

Es ist bereits mehrfach versucht worden, hochtemperaturbeständige Positivresists mit den oben beschriebenen erwünschten Eigenschaften herzustellen. Aus der US-A-4,093,461 ist zum Beispiel ein hitzebeständiges Positivresistgemisch aus einem Naphthochinondiazid und dem Polykondensationsprodukt eines aromatischen Dianhydrids (Pyromellithsäureanhydrid) mit einem aromatischen Diamin (4,4'-Diaminodiphenylether) bekannt. Die Eigenschaften des in dieser Patentschrift beschriebenen Positivresists werden in der US-A-4,395,482 (Spalte 1, Zeilen 46-64) kritisch beurteilt. Dort wird darauf hingewiesen, daß das Positivresistgemisch aus der US-A-4,093,461 eine begrenzte Lagerfähigkeit, eine unzureichende Beständigkeit gegen alkalische Ätzlösungen und relativ geringe Löslichkeitsunterschiede zwischen den belichteten und unbelichteten Bereichen des Resists aufweist.

Bisher war der Einsatz von bebilderbaren Polyimid-Resistsystemen durch eine zu geringe Lichtempfindlichkeit, die übermäßige Volumenkontraktion und Probleme mit der Lagerfähigkeit begrenzt. Die außergewöhnlichen dielektrischen Eigenschaften und die Hochtemperaturbeständigkeit von Polyimiden machten sie an sich besonders geeignet für die Halbleiterfertigung. Sie lassen sich z.B. als dielektrische Schichten, Sperrschichten für α-Teilchen in Speichervorrichtungen, Ionenimplantationsmasken und Passivierungsschichten einsetzen. Ziel vieler Entwicklungsprogramme war die Entwicklung eines einfachen, zuverlässigen und kostengünstigen strahlungsempfindlichen Polyimidsystems, das man mit den üblichen photolithographischen Verfahren verarbeiten könnte. Diesem Ziel galten auch die Arbeiten von R. Rubner, H. Ahne, E. Kuhn und G. Kolodziej in Phot. Sci. & Eng. 23(5), S. 303-309, (1979) und H. Ahne, H. Krüger, E. Pammer and R. Rubner: "Polyimide Synthesis, Characterization and Application", Hrsg. K.L. Mittal, Bd. 2, SS. 905-918, Plenum Press (1984). Die in diesen Veröffentlichungen beschriebenen Grundsysteme bestehen aus Polyamidcarbonsäure-Polymeren mit seitenständigen photoreaktiven Gruppen. Materialien auf der Basis dieser chemischen Struktur wiesen jedoch bisher die Nachteile einer schlechten Lagerfähigkeit, einer geringen Lichtempfindlichkeit und einer übermäßig starken Strukturkontraktion nach dem Entwickeln bzw. nach dem Aushärten auf. Diese Materialien ergaben zwar hochaufgelöste Strukturen, erforderten jedoch Belichtungszeiten von 10 Minuten oder länger. Auch die Lagerfähigkeit war schlecht, insbesondere bei den für das Aufbringen dicker Schichten benötigten hochkonzentrierten Lösungen; und die beim Aushärten eintretende Kontraktion der ursprünglichen Strukturen betrug bis zu 60 %.

Aromatische Polyimide mit freien Hydroxygruppen, hergestellt durch Umsetzung von Pyromellitsäure-dianhydrid mit entweder 3,3'-Diamino-4,4'-dihydroxy-biphenyl, 2,2-Bis-(3-amino-4-hydroxy-phenyl)-propan oder Bis-(3-amino-4-hydroxy-phenyl)-methan sind in Chemical Abstracts, Band 68, Nr. 18, Seite 6720, Referat Nr. 69434r, beschrieben.

Ein strahlungsempfindliches Gemisch, das neben einem organischen chromophoren Azid ein Polyimid aus aromatischen Tetracarbonsäuren und aromatischen Diaminen enthält, ist aus der EP-A 0 092 524 bekannt. Das Polyimid ist gekennzeichnet durch einen Mindestgehalt an aliphatischen Gruppen und/oder Brückengruppen, es kann jedoch auch freie Hydroxygruppen aufweisen, da unter den als Ausgangsmaterialien genannten aromatischen Diaminen 5,5'-Oxy-bis-(2-amino- phenol) und 5,5'-Sulfonyl-bis-(2-amino-phenol) aufgeführt sind. Weitere Hinweise auf hydroxygruppenhaltige Polyimide sind der EP-A nicht zu entnehmen.

Aufgabe der Erfindung war es, neue Polyimide zur Verfügung zu stellen, die als Schutz- und Planarisierungsschichten in der Photoresisttechnik sowie als Bindemittel für mit wäßrigen Alkalien entwickelbare Photoresistgemische guter Lagerfähigkeit geeignet sind, die bei der Verarbeitung eine geringe Volumkontraktion, eine hohe Auflösung und Lichtempfindlichkeit aufweisen.

Erfindungsgemäß wird ein Polyimid mit wiederkehrenden Einheiten der allgemeinen Formel I 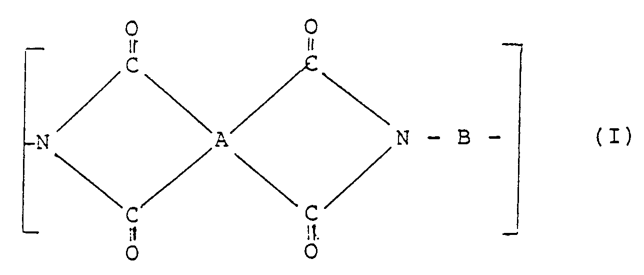
vorgeschlagen, worin
- A: der Rest einer Verbindung mit mindestens einem aromatischen Sechsring ist, wobei jede der vier Carbonylgruppen an ein anderes aromatisches Kohlenstoffatom von A gebunden ist und wobei jeweils zwei Carbonylgruppen an benachbarten Kohlenstoffatomen stehen, und
- B: der Rest einer Verbindung mit mindestens einem aromatischen Sechsring und mindestens einer Hydroxygruppe ist,
mit der Maßgabe,
daß entweder der Rest A der Formel IIIa 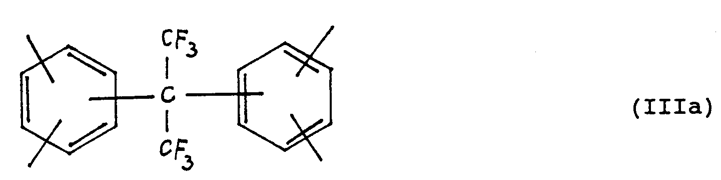
oder der Rest B der Formel IVa 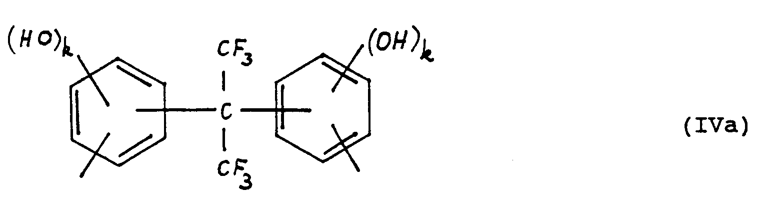
worin k für eine ganze Zahl von O bis 3 steht,
oder daß der Rest A der Formel IIIa und der Rest B der Formel IVa entspricht.

Erfindungsgemäß wird ferner ein Photoresistgemisch vorgeschlagen, das als wesentliche Bestandteile eine lichtempfindliche Verbindung und ein Polyimid enthält.

Das erfindungsgemäße Photoresistgemisch ist dadurch gekennzeichnet, daß das Polyimid eine Verbindung der vorstehenden Formel I ist.

Aus den erfindungsgemäßen lichtempfindlichen Gemischen können hochtemperaturbeständige Reliefstrukturen mit ausgezeichneter Auflösung und Haftung hergestellt werden.

Die erfindungsgemäßen Polyimide lassen sich ferner zur Herstellung hochtemperaturbeständiger Schutzüberzüge verwenden.

Die erfindungsgemäßen Hydroxypolyimide werden im allgemeinen durch Lösungskondensation von z.B. 2,2-Bis-(3-amino-4-hydroxyphenyl)-perfluorpropan mit einem Dianhydrid einer Tetracarbonsäure hergestellt. Ein Teil des 2,2-Bis-(3-amino-4-hydroxyphenyl)-perfluorpropans kann durch ein anderes Diamin-Comonomeres ersetzt werden, das keine phenolischen Hydroxygruppen enthält, um die Löslichkeit des Polymeren in wäßrig-alkalischen Lösungen in dem für das Beschichten verwendeten Lösemittel zu erhöhen. Die Löslichkeit des Polyimids im Entwickler kann auch dadurch reduziert oder seine Löslichkeit im Lösemittel dadurch erhöht werden, daß man einen Teil der Hydroxygruppen in dem Polymeren umsetzt, z.B. acyliert.

Es hat sich auch gezeigt, daß die Löslichkeit des Polyimids in Lösemitteln und seine Entwickelbarkeit in alkalischen Medien durch die Wahl des Aminophenols und des Dianhydrids gesteuert werden kann.

Beispiele für bevorzugte Dianhydride sind 2,2-Bis-(3,4-dicarboxyphenyl)-hexafluorpropan-dianhydrid (6F-Dianhydrid), 3,3',4,4'-Benzophenon-tetracarbonsäuredianhydrid (BTDA) und Bis-(dicarboxyphenyl)ether-dianhydrid.

Die Lichtempfindlichkeit des erfindungsgemäßen Resists kann z.B. auf Werte zwischen etwa 10 mJ/cm² und etwa 300 mJ/cm² eingestellt werden. Dieses Ergebnis wird durch Steuerung der Zusammensetzung der Polyimidkomponente erreicht.

Die Positivresists dieser Erfindung können nach dem Belichten in herkömmlicher Weise in einem wäßrig-alkalischen Entwickler entwickelt werden und ergeben feine Reliefstrukturen, die sich für die Anwendung in der Mikroelektronik und zur Herstellung von Druckplatten eignen. Diese Resists besitzen eine hohe thermische Stabilität (250 - 350° C), eine verbesserte Lichtempfindlichkeit, eine bessere Löslichkeit in den allgemein verwendeten Beschichtungslösemitteln und ein ausgezeichnetes Haftvermögen. Im Vergleich zu bekannten Resists auf Basis von Polyamidcarbonsäuren als Polyimidvorstufen haben die erfindungsgemäßen Resists eine hervorragende Lagerfähigkeit. Die Resistgemische können ohne Gelbildung und ohne Beeinträchtigung der Lichtempfindlichkeit oder Viskosität über längere Zeit bei Raumtemperatur gelagert werden.

Neben ihrer Verwendung in hochtemperaturbeständigen Positivresists können die erfindungsgemäßen Polyimide auch für die Herstellung von hochhitzebeständigen Schutzüberzügen eingesetzt werden.

Die erfindungsgemäßen Polyimide werden durch Kondensation mindestens eines hydroxy-substituierten aromatischen Diamins H₂N-B-NH₂ mit mindestens einem aromatischen Dianhydrid 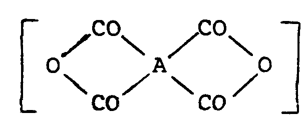
hergestellt.

Die Gruppierungen A und B in der oben angegebenen Formel I können gegebenenfalls durch Alkyl-, Alkoxy-, Aryl-, Aryloxy- oder andere inerte Reste substituiert sein.

Die vierwertige Gruppierung A besteht vorzugsweise aus gegebenenfalls substituierten Benzol-, Naphthalin- oder Polyphenylkernen mit bis zu vier, insbesondere zwei Phenylringen bzw. Mischungen daraus. Sie hat insbesondere die Formel III 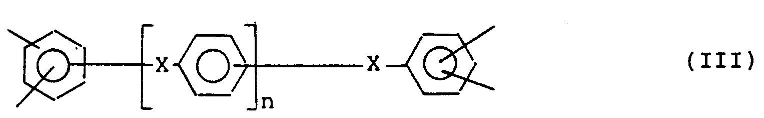
worin
- X: eine Einfachbindung, O, CO, SO₂ eine Alkylengruppe oder eine fluorierte Alkylengruppe mit 1 bis 6 Kohlenstoffatomen und
- n: 0, 1 oder 2 ist.

Beispiele für die Gruppe X sind C(CH₃)₂, C(CF₃)₂ und CH₃CCF₃; Hexafluorpropyliden-, Carbonyl- und Ethergruppen werden bevorzugt.

Die Gruppierung B besteht vorzugsweise aus Benzol- oder Polyphenylkernen mit bis zu sechs, insbesondere zwei Benzolringen bzw. Mischungen daraus. Besonders bevorzugt werden Gruppierungen B der Formel IV 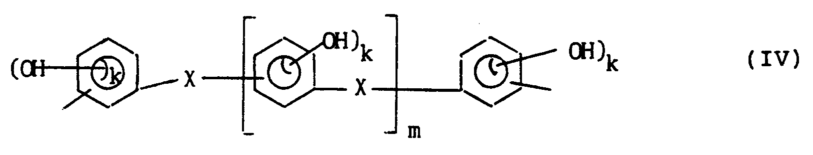
worin
- X: eine Einfachbindung, O, CO, SO₂, eine Alkylengruppe oder eine fluorierte Alkylengruppe mit 1 bis 6 Kohlenstoffatomen,
- m: eine Zahl von 0 bis 4 und
- k: für jeden Benzolring unabhängig eine Zahl von 0 bis 3 ist,
wobei der Rest B insgesamt mindestens eine OH-Gruppe enthält.

X ist besonders bevorzugt eine Hexafluorpropylidengruppe.

Ein Teil der aromatischen, hydroxy-substituierten Gruppierungen B kann durch aromatische Gruppierungen D ersetzt werden, die keine Hydroxy-Substituenten enthalten, so daß sich ein Copolyimid mit Einheiten der oben angegebenen Formel I und Einheiten der allgemeinen Formel II ergibt: 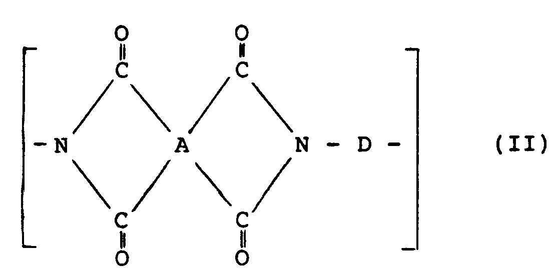
worin D ein von Hydroxygruppen freier aromatischer Rest mit mindestens einem aromatischen Sechsring ist und A die oben angegebene Bedeutung hat. D besteht aus aromatischen, zweiwertigen Kernen oder Mischungen daraus, die keine Hydroxy-Substituenten enthalten. Das Polyimid enthält bis zu 80, vorzugsweise bis zu 50 und insbesondere bis zu 30 mol-% an Einheiten der Formel II, bezogen auf die Summe der Einheiten I und II.

Darüber hinaus können die erfindungsgemäßen Copolyimide durch Anfügen aliphatischer und alicyclischer Gruppen oder Reste an die Polyimidkette weiter modifiziert werden. Die aliphatische und/oder alicyclische Komponente kann hydroxysubstituiert sein, wenn sie als die Diaminkomponente vorliegt. Der Anteil an aliphatischen und alicyclischen Gruppen sollte höchstens 50 mol-%, vorzugsweise höchstens 30 mol-% des Copolyimids betragen.

Die Gruppierung D ist vorzugsweise eine zweiwertige Gruppe entsprechend der Formel V 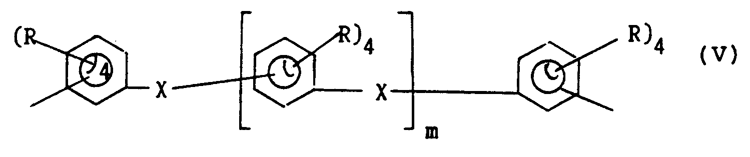
worin
- X: eine Einfachbindung, O, CO, SO₂, eine Alkylengruppe oder eine fluorierte Alkylengruppe mit 1 bis 6 Kohlenstoffatomen,
- R: für jeden Fall unabhängig ein Wasserstoff- oder Halogenatom, eine Alkyl- oder Alkoxygruppe mit 1 bis 6 Kohlenstoffatomen oder eine Acylgruppe mit 2 bis 10 Kohlenstoffatomen und
- m: eine Zahl von 0 bis 4 ist.

In der Formel V ist m vorzugsweise 0 und X vorzugsweise eine Hexafluorpropylidengruppe.

Für die Herstellung der erfindungsgemäßen Polyimide geeignete aromatische Dianhydride sind zum Beispiel Pyromellithsäuredianhydrid, 2,3,6,7-Naphthalin-tetracarbonsäuredianhydrid, 3,3',4,4'-Diphenyl-tetracarbonsäuredianhydrid, 1,2,5,6-Naphthalin-tetracarbonsäuredianhydrid, 2,2',3,3'-Diphenyl-tetracarbonsäuredianhydrid, 2,2-Bis-(3,4-dicarboxyphenyl)propandianhydrid, 2,2-Bis-(3,4-dicarboxyphenyl)-hexafluorpropandianhyrid, Bis-(3,4-dicarboxyphenyl)-sulfondianhydrid, 3,4,9,10-Perylen-tetracarbonsäuredianhydride, Bis-(3,4-dicarboxyphenyl)etherdianhydrid, 2,2-Bis-(2,3-dicarboxyphenyl)propandianhydrid; 1,1-Bis-(2,3-dicarboxyphenyl)ethandianhydrid, Bis-(3,4-dicarboxyphenyl)methandianhydrid, Bis-(2,3-dicarboxyphenyl)sulfondianhydrid und Benzophenon-tetracarbonsäuredianhydrid. Die Verfahren zur Herstellung dieser aromatischen Dianhydride sind bekannt und z.B. in den US-A-3,310,573; 3,408,411; 3,553,282 und 4,030,948 beschrieben.

Beispiele für hydroxy-substituierte aromatische Diamine der Formel NH₂-B-NH₂ sind: 3,3'-Dihydroxybenzidin, 3,4'-Diamino-3',4-dihydroxy-biphenyl, 3,3'-Dihydroxy-4,4'-diamino-diphenyloxid, 3,3'-Dihydroxy-4,4'-diamino-diphenylsulfon, 2,2-Bis-(3-amino-4-hydroxyphenyl)propan, Bis-(3-hydroxy-4-aminophenyl)methan, 2,4-Diaminophenol, 3,3'-Dihydroxy-4,4'-diamino-benzophenon, 1,1-Bis-(3-hydroxy-4-aminophenyl)-ethan, 1,3-Bis-(3-hydroxy-4-aminophenyl)propan, 2,2-Bis(3-hydroxy-4-aminophenyl)propan und 2,2-Bis-(3-amino-4-hydroxyphenyl)hexafluorpropan.

Ihre Herstellung ist bekannt und zum Beispiel in J. Polymer Sci., Bd. 20, Ss. 2381-2391, (1982), beschrieben.

Ein Teil der hydroxy-substituierten aromatischen Diamine kann, wie oben erwähnt, durch ein Diamin der Formel NH₂-D-NH₂ ersetzt werden, worin D die oben angegebene Bedeutung hat.

Beispiele für aromatische Diamine der Formel NH₂-D-NH₂ sind:
m-Phenylendiamin, p-Phenylendiamin, 4,4′-Diaminodiphenylether, 3,3′-Diaminophenylether, 3,4′-Diaminodiphenylether, 1,3-Bis-(aminophenoxy)benzol, 1,4-Bis-(aminophenoxy)-benzol, Benzidin, 3,3′-Dimethoxy-benzidin, 3,3′-Dimethyl-benzidin, 3,3′-Diethyl-benzidin, 3,3′-Diaminodiphenylmethan, 4,4′-Diamino-diphenylmethan, 4,4′-Diaminodiphenylpropan, 3,3′-Diamino-diphenylsulfon, 4,4′-Diaminodiphenylsulfon, 4,4′-Diaminodiphenylsulfid, 2,2′-Bis-(4-aminophenyl)perfluorpropan, α,α-Bis-(aminophenyl)-p-diisopropylbenzol, 1,3-Bis-(4-aminophenoxy)benzol, 2,2-Bis-[4-(4-aminophenoxy)phenyl]-hexafluorpropan, 2,2-Bis-(3-aminophenyl)-hexafluorpropan, m-Xylylendiamin, p-Xylylendiamin, 4,4′-Bis-(p-aminophenoxy)-diphenylsulfid, 4,4′-Bis-(3-aminophenoxy)-diphenylsulfid, 4,4′-Bis-(p-aminophenoxy)-diphenylsulfon, 4,4′-Bis-(3-aminophenyl)-sulfon, 2,2-Bis-(4-aminophenoxy-phenyl)-propan und Gemische dieser Verbindungen.

Für die Herstellung von Copolyimiden geeignete aliphatische und alicyclische Diamine sind z.B.:
1,2-Bis-(3-aminopropoxy)ethan, Bis-(4-aminocyclohexyl)-methan, Hexamethylendiamin, Octamethylendiamin, 1,4-Cyclohexandiamin, Decamethylendiamin, Dodecamethylendiamin, Bis-(3-aminopropyl)sulfid, 3-Hydroxy-hexamethylendiamin, 1,3-Diamino-2-hydroxypropan, 2,6-Diaminocyclohexanol.

Für die Herstellung von erfindungsgemäßen Copolyimiden geeignete aliphatische und alicyclische Dianhydride sind zum Beispiel: Ethylentetracarbonsäuredianhydrid, 1,2,3,4-Butan-tetracarbonsäuredianhydrid, 1,2,3,4-Cyclopentan-tetracarbonsäuredianhydrid und 2,3,5,6-Cyclohexan-tetracarbonsäuredianhydrid.

Von den Polyimiden sind diejenigen besonders bevorzugt, die aus 2,2-Bis-(3-amino-4-hydroxyphenyl)perfluorpropan und 2,2-Bis-(3,4-dicarboxyphenyl)-hexafluorpropandianhydrid erhalten worden sind. Weitere Beispiele für bevorzugte Polyimide sind solche, die aus dem gleichen Diamin und einem der folgenden Dianhydride: Bis-(3,4-dicarboxyphenyl)ether-dianhydrid, 3,3′,4,4′-Benzophenon-tetracarbonsäuredianhydrid und 2,2-Bis-(3,4-dicarboxyphenyl)-hexafluorpropandianhydrid hergestellt werden. Bevorzugte Diamin-Comonomere sind z.B. 2,2-Bis-(3-aminophenyl)-hexafluorpropan und 2,2-Bis-(4-aminophenyl)-hexafluorpropan.

Es können auch Gemische aus den Diamin- und Dianhydrid-Monomeren verwendet werden, was zu Copolyimiden mit hervorragenden Eigenschaften führt. Besonders bevorzugt werden Polyimide, die mindestens 50 mol-%, insbesondere mindestens 70 mol-%, Einheiten aus 2,2-Bis-(3-amino-4-hydroxyphenyl)-hexafluorpropan enthalten.

Das Polyimid kann auch nach der Polymerisation modifiziert werden, indem man z.B. einen Teil der Hydroxygruppen in dem Polymeren mit einem Acylierungsmittel mit bis zu 10 C-Atomen, z.B. Essigsäureanhydrid, Propionsäureanhydrid, Benzoylchlorid oder Diketen acyliert.

Die erfindungsgemäßen Polyimide werden nach bekannten Polymerisationsverfahren hergestellt; im allgemeinen durch Kondensation in Lösung bei erhöhter Temperatur unter Verwendung von p-Toluolsulfonsäure als Katalysator (siehe z.B. EP-A-0 163 518).

Die Polyimide dieser Erfindung eignen sich für die Herstellung von positiv arbeitenden Photoresistgemischen. Diese Resistgemische enthalten ein Polyimid, wie oben beschrieben, und eine strahlungs- bzw. lichtempfindliche Verbindung.

Die Verwendung von strahlungsempfindlichen Verbindungen, z.B. o-Chinondiaziden ist bekannt, z.B. aus "Light-Sensitive Systems" von J. Kosar, Verlag John Wiley & Sons, New York, 1965, Kapitel 7.4. Als strahlungsempfindiche Verbindungen können substituierte Naphthochinondiazide eingesetzt werden, die normalerweise in Positivresists verwendet werden. Solche strahlungsempfindlichen Verbindungen sind zum Beispiel in den US-A-2,797,213; 3,106,465; 3,148,983; 3,130,047; 3,201,329; 3,785,825 und 3,802,885 beschrieben. Geeignet sind z.B. die Kondensationsprodukte aus 1,2-Naphthochinon-2-diazid-5- oder -4-sulfonylchlorid mit Phenolen, z.B. Hydroxybenzophenonen.

Im allgemeinen kann jede strahlungsempfindliche Verbindung oder jedes strahlungsempfindliche Gemisch mit den erfindungsgemäßen Hydroxypolyimiden verwendet werden, sofern 1.) die Verbindung oder das Gemisch die Löslichkeit des Polyimids im Entwickler unterbindet und 2.) die Verbindung oder das Gemisch bei der Belichtung mit aktinischer Strahlung direkt oder indirekt in Moleküle mit erhöhter Löslichkeit, Klebrigkeit oder Flüchtigkeit umgewandelt wird. Solche strahlungsempfindlichen Gemische sind aus den US-A-4,247,611 und 4,619,998 bekannt.

Strahlungsempfindliche Gemische, wie sie aus den oben genannten Patenten bekannt sind, bestehen aus einer strahlungsempfindlichen Verbindung, die bei Belichtung Säure bildet und einer zweiten Verbindung mit mindestens einer durch Säure spaltbaren Gruppe.

Beispiele für säurespaltbare Verbindungen sind:
A. Verbindungen mit mindestens einer Orthocarbonsäureester- und/oder Carbonsäureamidacetalgruppe, wobei die Verbindungen auch polymeren Charakter haben können und die oben genannten Gruppen als Bindeglieder in der Hauptkette oder als seitenständige Gruppen anwesend sein können.
B. Polymere Verbindungen mit wiederkehrenden Acetal- und/oder Ketalgruppen, in denen vorzugsweise beide α-Kohlenstoffatome der für die Bildung der Gruppen erforderlichen Alkohole aliphatisch sind.

Säurespaltbare Verbindungen des Typs A als Komponenten von strahlungsempfindlichen Gemischen sind in den US-A-4,101,323 und 4,247,611 ausführlich beschrieben, während Gemische mit Verbindungen des Typs B Gegenstand der US-A-4,189,323 sind.

Zu den geeigneten säurespaltbaren Verbindungen zählen z.B. auch die aus der DE-C-23 06 248 bekannten bestimmten Aryl-alkylacetale und -aminale. Weitere Verbindungen dieser Art sind Enolether und Acyliminocarbonate, wie sie in den EP-A-0 006 626 und 0 006 627 beschrieben sind.

Als strahlungsempfindliche, bei Bestrahlung säurebildende oder säureabspaltende Bestandteile können zahlreiche bekannte Verbindungen und Mischungen verwendet werden, z.B. Diazoniumsalze, Phosphoniumsalze, Sulfoniumsalze und Jodoniumsalze oder Halogenverbindungen, Chinondiazidsulfonsäurechloride und Organometall/Organohalogen-Kombinationen. Geeignete Diazoniumsalze sind die Verbindungen mit einem nutzbaren Absorptionsbereich zwischen 300 und 600 nm. Im allgemeinen werden diese Diazonium-, Phosphonium-, Sulfonium- und Jodoniumverbindungen in Form ihrer in organischen Lösemitteln löslichen Salze, normalerweise als Abscheidungsprodukte mit komplexen Säuren, z.B. Borfluorwasserstoff-, Hexafluorphosphor-, Hexafluorantimon- oder Hexafluorarsensäure eingesetzt. Auch Derivate von positiv arbeitenden o-Chinondiaziden können verwendet werden. Aus dieser Gruppe von Verbindungen wird 1,2-Naphthochinondiazid-4-sulfonsäurechlorid bevorzugt, weil bei dessen Belichtung drei Säurefunktionen gebildet werden, die bei der Spaltung der Polyacetale und Polyketale ein relativ hohes Maß an Intensivierung bewirken.

Grundsätzlich können alle als Radikalstarter bekannten organischen Halogenverbindungen, z.B. solche, die mehr als ein an ein Kohlenstoffatom oder einen aromatischen Ring gebundenes Halogenatom enthalten, als halogenhaltige, zur Bildung von Halogenwasserstoffsäure befähigte strahlungsempfindliche Verbindungen verwendet werden. Beispiele für solche Verbindungen sind aus den US-A-3,515,552;3,536,489; 3,779,778 und 3,395,475 bekannt. Ferner können bestimmte substituierte Trichlormethylpyrone, wie sie in der US-A-4,101,323 beschrieben sind, und die aus der US-A-4,189,323 bekannten 2-Aryl-4,6-bis-trichlormethyl-s-triazine als säurebildende Komponenten verwendet werden.

Beispiele für geeignete säurebildende Verbindungen sind:
4-(Di-n-propylamino)-benzoldiazoniumtetrafluoroborat, 4-p-Tolylmercapto-2,5-diethoxybenzoldiazonium-hexafluorophosphat, 4-p-Tolylmercapto-2,5-diethoxy-benzoldiazonium-tetrafluoroborat, Diphenylamin-4-diazoniumsulfat, 4-Methyl-6-trichlormethyl-2-pyron, 4-(3,4,5-Trimethoxy-styryl)-6-trichlormethyl-2-pyron, 4-(4-Methoxystyryl)-6-(3,3,3-trichlorpropenyl)-2-pyron, 2-Trichlormethyl-benzimidazol, 2-Tribrommethyl-chinolin, 2,4-Dimethyl-1-tribromacetyl-benzol, 3-Nitro-1-tribromacetyl-benzol, 4-Dibromacetylbenzoesäure, 1,4-Bis-dibrommethyl-benzol, Tris-dibrommethyl-s-triazin; 2-(6-Methoxy-naphth-2-yl)-, 2-(Naphth-1-yl)-, 2-(Naphth-2-yl)-, 2-(4-Ethoxyethyl-naphth-1-yl), 2-Benzopyran-3-yl)-, 2-(4-Methoxy-anthrac-1-yl)- und 2-(Phenanthr-9-yl)-4,6-bis-trichlormethyl-s-triazin.

Vor dem Aufbringen auf einen Schichtträger können der Lösung aus Polyimid, strahlungsempfindlicher Verbindung und Lösemittel noch Zusatzstoffe, z.B. Pigmente, Farbstoffe, Verlaufmittel, Weichmacher, Haftvermittler, Entwicklungsbeschleuniger, Lösemittel und nichtionische Tenside zugesetzt werden.

Beispiele für Farbstoffe, die den erfindungsgemäßen Photoresistgemischen zugesetzt werden können, sind: Methylviolett 2B (C.I.42 535), Kristallviolett (C.I. 42 555), Malachitgrün (C.I. 42 000), Viktoriablau B (C.I. 44 045) und Neutralrot (C.I. 50 040). Diese Farbstoffe werden in Anteilen von 1-10 Gew.-%, bezogen auf das Gesamtgewicht von Polyimid und lichtempfindlicher Verbindung zugesetzt. Die Farbstoffzusätze verhelfen zu einer hohen Auflösung, indem sie die Reflexion des Lichts am Schichtträger verhindern.

Verlaufmittel können in einem Anteil von bis zu 5 Gew.-% vom gemeinsamen Gewicht von Polyimid und strahlungsempfindlicher Verbindung verwendet werden.

Geeignete Haftvermittler sind z.B. β-(3,4-Epoxycyclohexyl)-ethyltrimethoxysilan, Vinyltrichlorsilan und γ-Aminopropyltriethoxysilan, die in einem Anteil bis zu 4 Gew.-% des Gesamtgewichts von Polyimid und strahlungsempfindlicher Verbindung eingesetzt werden können.

Als Entwicklungsbeschleuniger können z.B. Pikrinsäure, Nicotinsäure oder Nitrozimtsäure in einem Anteil bis zu 20 Gew.-% vom Geamtgewicht von Polyimid und strahlungsempfindlicher Verbindung zugesetzt werden. Diese Beschleuniger haben die Tendenz, die Löslichkeit der Resistbeschichtung sowohl in den belichteten als auch in den unbelichteten Bereichen zu erhöhen, und sie werden deshalb dort angewendet, wo es vor allem auf die Entwicklungsgeschwindigkeit ankommt, auch wenn dabei möglicherweise ein gewisses Maß an Kontrast geopfert wird, d.h. der Entwickler löst die belichteten Bereiche der Resistbeschichtung zwar rascher, aber gleichzeitig verursachen die Entwicklungsbeschleuniger auch einen größeren Abtrag der Resistbeschichtung in den unbelichteten Bereichen.

Zur Herstellung der erfindungsgemäßen Resistgemische können die auf diesem Gebiet verwendeten, normalen im Handel erhältlichen Lösemittel eingesetzt werden. Die bei der Herstellung der Resistlösung verwendete Lösemittelmenge kann bis zu 95 % vom Gewicht der Lösung ausmachen. Die bekannten Polyimide sind in N-Methylpyrrolidon und Dimethylacetamid nur begrenzt löslich, während die erfindungsgemäßen Polyimide eine verbesserte Löslichkeit in diesen und weiteren, für den kommerziellen Einsatz geeigneten Lösemitteln aufweisen. Geeignete Lösemittel sind z.B. N-Methylpyrrolidon, Dimethylacetamid, Propylenglykolmonomethylether, Methylethylketon, Cyclohexanon, Butyrolacton und Mischungen daraus. Die bevorzugten Lösemittel sind N-Methylpyrrolidon und Propylenglykolmonomethylether.

Die Resistlösung kann nach einem in der Resisttechnik üblichen Verfahren auf einen Schichtträger aufgebracht werden, z.B. durch Tauchbeschichten, Sprühen oder Aufschleudern. Beim Aufschleudern kann z.B. der Feststoffgehalt der Resistlösung auf einen bestimmten Wert eingestellt werden, um bei vorgegebener Aufschleudervorrichtung und Zeitspanne für den Aufschleudervorgang eine Beschichtung der gewünschten Dicke zu erhalten. Geeignete Schichtträger sind z.B. Silicium, Aluminium, Polymere, Siliciumdioxid, dotiertes Siliciumdioxid, Siliciumnitrid, Tantal, Kupfer, Polysilicium, Keramik und Aluminium-Kupferlegierungen.

Die erfindungsgemäßen Resistgemische eignen sich insbesondere für das Aufbringen auf Siliciumwafer, die mit thermisch gezüchtetem Siliciumdioxid beschichtet sind, so wie sie für die Herstellung von Mikroprozessoren und anderen miniaturisierten Bauelementen für integrierte Schaltungen verwendet werden. Ein Schichtträger aus Aluminium/Aluminiumoxid ist ebenfalls geeignet oder auch ein Schichtträger aus verschiedenen Polymeren, besonders aus transparenten Polymeren, z.B. Polyestern.

Bevorzugte Entwicklerlösungen für die strahlungsempfindlichen Gemische dieser Erfindung sind wäßrige Lösungen von anorganischen alkalischen Verbindungen, z.B. wäßrige Lösungen von Natriumsilikat, Kaliumsilikat, Natriumhydroxid, Kaliumhydroxid, Lithiumhydroxid, Natriumphosphat, Natriummonohydrogenphosphat, Ammoniumphosphat, Ammoniummonohydrogenphosphat, Natriummetasilikat, Natriumbicarbonat, Ammoniak usw., wobei die Konzentration dieser Verbindungen zweckmäßig zwischen 0,1 und 10 Gew.-%, vorzugsweise zwischen 0,5 und 5 Gew.-%, liegt. Beispiele für solche Entwicklerlösungen sind in den US-A-3,110,596; 3,173,788 und 3,586,504 beschrieben.

Eine alkalische Lösung dieser Art kann je nach Bedarf auch bestimmte organische Lösemittel, wie Alkohole (z.B. Methanol, Ethanol, Benzylalkohol usw.), und ein Tensid (z.B. Natrium-alkylnaphthalinsulfonat, Natriumlaurylsulfat usw.) enthalten.

Nachdem die Lösung des Resistgemischs auf den Schichtträger aufgebracht worden ist, wird dieser auf etwa 80 - 105° C, z.B. auf etwa 90° C, so lange erwärmt, bis das Lösemittel im wesentlichen vollständig vertrieben ist und nur eine dünne Schicht von etwa 1 µm Dicke aus dem Photoresistgemisch auf dem Schichtträger zurückbleibt. Auf den beschichteten Schichtträger kann dann mit aktinischem Licht jede gewünschte Struktur aufbelichtet werden, die mit Hilfe von geeigneten Masken, Negativen, Schablonen usw. erzeugt wird.

Die belichteten resistbeschichteten Schichtträger werden anschließend in eine Entwicklerlösung eingetaucht, die vorzugsweise, z.B. durch Einblasen von Stickstoff, in Bewegung gehalten wird.

Man beläßt die Schichtträger so lange im Entwickler, bis sich die gesamte oder im wesentlichen die gesamte Resistbeschichtung aus den belichteten Bereichen weggelöst hat.

Nach Entnahme der beschichteten Wafer aus der Entwicklerlösung kann eine Nacherhitzung erfolgen, durch die die Haftung der Beschichtung und ihre chemische Beständigkeit gegen Ätzlösungen und andere Substanzen erhöht werden sollen. Die erfindungsgemäßen Resistgemische weisen eine ausgezeichnete Haftfähigkeit auf Schichtträgern, wie Siliciumwafern, Aluminiumplatten, Glas, Polyesterfolien usw. auf. Zur Verarbeitung der Resists ist kein Haftvermittler erforderlich.

Nach dem Härten kann der entwickelte Schichtträger mit einer gepufferten Fluorwasserstoffsäure- oder alkalischen Ätzlösung behandelt werden. Die erfindungsgemäßen Resistgemische sind beständig gegen saure und alkalische Ätzlösungen und stellen einen wirksamen Schutz für die unbelichteten (resistbeschichteten) Bereiche des Schichtträgers dar. Der entwickelte und gehärtete Photoresist ergibt Reliefstrukturen mit sehr hoher Auflösung und hoher thermischer Stabilität.

Obwohl sich die obige Beschreibung auf ein Naßätzverfahren bezieht, können die erfindungsgemäßen Reliefstrukturen sowohl bei Naß- als auch bei Trockenätzverfahren eingesetzt werden. Die resultierenden Strukturen sind besonders gute Isolierschichten für Anwendungen in der Mikroschaltungstechnik, sie lassen sich als Masken für Aufdampfverfahren und Ionenimplantationsverfahren verwenden. Die erfindungsgemäßen Resists können ebenso bei der Herstellung von Druckplatten, Farbprüffolien, Transferfolien und anderen ähnlichen Anwendungen eingesetzt werden. Die Herstellung von Druckplatten unter Verwendung positiv arbeitender lichtempfindlicher Gemische ist zum Beispiel aus der US-A-3,493,371 bekannt.

Die Gemische können auch als normale Schutzüberzüge für viele Anwendungszwecke eingesetzt werden. So sind die erfindungsgemäßen Polyimide durch ihre hohe Löslichkeit zum Beispiel für hochtemperaturbeständige Schutzüberzüge an sich sowie für Resistanwendungen besonders geeignet. Bei einem typischen Beschichtungsvorgang wird ein Beschichtungsgemisch, das etwa 5 - 30 Gew.-% des erfindungsgemäßen Polyimids in Lösung enthält, auf einen Träger aufgebracht. Das Beschichtungsgemisch kann gegebenenfalls noch Antioxidantien, UV-Stabilisatoren, Haftvermittler, Farbstoffe, Pigmente, flammenhemmende Stoffe, Füllstoffe und andere Hilfsstoffe in Anteilen bis zu 20 Gew.-% enthalten. Das Lösemittel wird bei einer Temperatur von im allgemeinen 90 - 150° C vertrieben, wobei auch mit Unterdruck gearbeitet werden kann, um das Lösemittel leichter zu entfernen. Anschließend kann der polyimidbeschichtete Träger zur Härtung der Beschichtung weiter wärmebehandelt werden.

In den folgenden Beispielen werden die Verfahren zur Herstellung und Anwendung von erfindungsgemäßen Gemischen näher erläutert. In den Beispielen ist der Begriff Dunkelabtragsrate der Schicht auf Abtragsrate abgekürzt.

### Beispiel 1

Dieses Beispiel beschreibt die Herstellung eines Hydroxypolyimids mit wiederkehrenden Struktureinheiten der Formel I mit A = 2,2-Diphenyl-perfluorpropan-3',3'',4',4''-tetrayl und B = 2,2-Bis-(4-hydroxy-phenyl)perfluorpropan-3',3''-diyl.

In einem 500 ml-Vierhalskolben mit Thermometer, Kühler, Wasserabscheider, mechanischem Rührer und Stickstoffeinleitungsrohr werden unter Stickstoffatmosphäre 7,32 g (0,02 mol) 2,2-Bis-(3-amino-4-hydroxyphenyl)-hexafluorpropan (6F-Aminophenol) zusammen mit 128 ml Monochlorbenzol (MCB) (80%-ig) und 32 ml N-Methylpyrrolidon (NMP) (20%ig) eingefüllt. Die Mischung wurde gerührt, bis man eine klare Lösung erhielt, und dann wurden 8,88 g (0,02 mol) 2,2-Bis-(3,4-dicarboxyphenyl)-hexafluorpropan-dianhydrid zugegeben. Der Kolbeninhalt wurde auf 90° C erhitzt, mit 0,04 g Paratoluolsulfonsäure (PTSA) versetzt und anschließend zum Rückfluß erhitzt (etwa 142° C). In der ersten Stunde wurden etwa 100 ml des Wasser-Chlorbenzol-Azeotrops im Wasserabscheider aufgefangen. In den Kolben wurden dann 100 ml frisches Chlorbenzol gegeben und der Inhalt 10 Stunden bei 142 - 145° C am Rückfluß sieden gelassen.

Danach wurden 100 ml NMP zugegeben und das Monochlorbenzol bei 160 - 165° C abdestilliert. Das Reaktionsgemisch wurde abgekühlt und in einem Eis-Wasser-Methanol-Gemisch langsam ausgefällt. Es resultierte ein weißer Niederschlag, der mit heißem Wasser gründlich gewaschen wurde. Das Polymere wurde über Nacht im Vakuumtrockenschrank bei 125° C getrocknet.

Das Polymere hatte eine Viskosität (inherent viscosity) von 0,50 dl/g in Dimethylacetamid bei 25° C und war in den üblichen organischen Lösemitteln, wie N-Methylpyrrolidon, Dimethylactamid, Tetrahydrofuran, Diethylenglykolmonomethylether, Propylenglykolmonomethylether (PGME) und Ethylenglykolmonomethylether löslich. Die durch Differenz-Thermoanalyse (DTA) ermittelte Glastemperatur (Tg) des Polymeren betrug 306° C.

### Beispiel 2

Dieses Beispiel beschreibt die Herstellung eines Hydroxypolyimids mit wiederkehrenden Struktureinheiten der Formel I, in denen A eine Diphenylether-3,3',4,4'-tetraylgruppe ist und B die gleiche Bedeutung wie in Beispiel 1 hat.

In einen 500 ml-Vierhalskolben mit Thermometer, Kühler, Wasserabscheider, mechanischem Rührer und Stickstoffeinleitungsrohr wurden unter Stickstoff 7,32 g (0,02 mol) 6F-Aminophenol zusammen mit 128 ml Monochlorbenzol (80%ig) und 32 ml N-Methylpyrrolidon (20%ig) gegeben. Die Mischung wurde gerührt, bis man eine klare Lösung erhielt und dann 6,2 g (0,02 mol) Bis-(3,4-dicarboxyphenyl)ether-dianhydrid zugegeben. Der Kolbeninhalt wurde auf 90° C erhitzt, mit 0,04 g p-Toluolsulfonsäure versetzt und anschließend zum Rückfluß erhitzt (etwa 142° C). In der ersten Stunde wurden etwa 100 ml des Wasser-Chlorbenzol-Azeotrops im Wasserabscheider abgeschieden. In den Kolben wurden dann 100 ml frisches Chlorbenzol gegeben und der Inhalt 10 Stunden auf 142 - 145° C am Rückfluß erhitzt.

Danach wurden 100 ml NMP in den Kolben gegeben und überschüssiges Monochlorbenzol bei 160 - 165° C abdestilliert. Das Reaktionsgemisch wurde abgekühlt und in einem Eis-Wasser-Methanol-Gemisch langsam ausgefällt. Es resultierte ein weißer Niederschlag, der mit heißem Wasser gründlich gewaschen wurde. Das Polymere wurde über Nacht im Vakuumtrockenschrank bei 125° C getrocknet.

Das Polymere hatte eine Viskosität von 0,50 dl/g in Dimethylacetamid bei 25° C und war in den üblichen organischen Lösemitteln, wie N-Methylpyrrolidon, Dimethylacetamid, Tetrahydrofuran, Diethylenglykolmonomethylether, Propylenglykolmonomethylether, löslich. Die Glastemperatur (Tg) des Polymeren betrug 251° C.

### Beispiel 3

Dieses Beispiel beschreibt die Herstellung eines Hydroxypolyimids mit wiederkehrenden Struktureinheiten der Formel I, in denen A eine Benzophenon-3,3',4,4'-tetraylgruppe ist und B die gleiche Bedeutung wie in Beispiel 1 hat.

In einen 500 ml-Vierhalskolben mit Thermometer, Kühler, Wasserabscheider, mechanischem Rührer und Stickstoffeinleitungsrohr wurden unter Stickstoffatmosphäre 7,32 g (0,02 mol) 6F-Aminophenol zusammen mit 128 ml Monochlorbenzol (80%ig) und 32 ml N-Methylpyrrolidon (20%ig) gegeben. Die Mischung wurde gerührt, bis man eine klare Lösung erhielt und dann 6,48 g (0,02 mol) 3,3',4,4'-Benzophenon-tetracarbonsäuredianhydrid (BTDA) zugegeben. Der Kolbeninhalt wurde auf 90° C erhitzt, mit 0,04 g p-Toluolsulfonsäure versetzt und anschließend zum Rückfluß erhitzt (etwa 142° C). In der ersten Stunde wurden etwa 100 ml des Wasser-Chlorbenzol-Azeotrops im Wasserabscheider abgetrennt. In den Kolben wurden dann 100 ml frisches Chlorbenzol gegeben und der Inhalt 10 Stunden zum Rückfluß erhitzt.

Danach wurden 100 ml NMP in den Kolben gegeben und überschüssiges Monochlorbenzol bei 160 - 165° C abdestilliert. Das Reaktionsgemisch wurde abgekühlt und in einem Eis-Wasser-Methanol-Gemisch langsam ausgefällt. Es resultierte ein weißer Niederschlag, der mit heißem Wasser gründlich gewaschen wurde. Das Polymere wurde über Nacht im Vakuumtrockenschrank bei 125° C getrocknet.

Das Polymere hatte eine Viskosität von 0,51 dl/g in Dimethylacetamid bei 25° C und war in den üblichen organischen Lösemitteln, wie N-Methylpyrrolidon, Dimethylacetamid, Tetrahydrofuran, Diethylenglykolmonomethylether, Propylenglykolmonomethylether und Ethylenglykolmonomethylether löslich.

### Beispiel 4

Dieses Beispiel beschreibt die Herstellung von Copolyimiden mit wiederkehrenden Struktureinheiten der Formel I und II, worin A in beiden Fällen die gleiche Bedeutung wie in Beispiel 1 hat, B ebenfalls die in Beispiel 1 angegebene Bedeutung hat und D eine 2,2-Diphenyl-perfluorpropan-4',4''-diylgruppe ist. Das Polymere enthält 80 mol-% Einheiten der Formel I und 20 mol-% Einheiten der Formel II.

In einen 500 ml-Vierhalskolben mit Thermometer, Kühler, Wasserabscheider, mechanischem Rührer und Stickstoffeinleitungsrohr wurden unter Stickstoff 5,856 g (0,016 mol) 6F-Aminophenol und 1,336 g (0,004 mol) 2,2-Bis-(4-aminophenyl)-hexafluorpropan zusammen mit 128 ml Monochlorbenzol (MCB) (80%ig) und 32 ml N-Methylpyrrolidon (NMP) (20%ig) gegeben. Die Mischung wurde gerührt, bis man eine klare Lösung erhielt und dann 8,88 g (0,01 mol) des in Beispiel 1 angegebenen Dianhydrids zugegeben. Der Kolbeninhalt wurde auf 90° C erhitzt, mit 0,04 g p-Toluolsulfonsäure versetzt und anschließend zum Rückfluß erhitzt (etwa 142° C). In der ersten Stunde wurden etwa 100 ml des Wasser-Chlorbenzol-Azeotrops im Wasserabscheider abgetrennt. In den Kolben wurden dann 100 ml frisches Chlorbenzol gegeben und der Inhalt 10 Stunden zum Rückfluß erhitzt.

Danach wurden 100 ml NMP in den Kolben gegeben und überschüssiges Monochlorbenzol bei 160 - 165° C abdestilliert. Das Reaktionsgemisch wurde abgekühlt und langsam in ein Eis-Wasser-Methanol-Gemisch gegeben. Es resultierte ein weißer Niederschlag, der mit heißem Wasser gründlich gewaschen wurde. Das Polymere wurde über Nacht im Vakuumtrockenschrank bei 125° C getrocknet.

Das Polymere hatte eine Viskosität von 0,65 dl/g in Dimethylacetamid bei 25° C und war in den üblichen organischen Lösemitteln löslich.

### Beispiel 5

Zur Herstellung einer Photoresistlösung wurden 10 Gew.-teile des Hydroxypolyimids aus Beispiel 1, 0,5 Gew.-teile 2,3,4-Trihydroxybenzophenon-tris-1,2-Naphthochinon-2-diazid-5-sulfonsäureester und 0,08 Gew.-teile roter Farbstoff in 10 Gew.-teilen N-Methylpyrrolidon und 10 Gew.-teilen Propylenglykolmonomethylether gelöst. Die Lösung wurde filtriert und dann durch Walzenbeschichtung auf eine anodisierte Aluminiumplatte aufgebracht. Nach 30 Minuten Trocknen bei 90° C erhielt man eine 2 - 3 µm dicke Resistschicht. Diese Schicht wurde mit einer Photomaske mit Linienstruktur so abgedeckt, daß sich Schicht und Maske in engem Kontakt miteinander befanden. Dann wurde mit einer Quecksilberdampflampe von 200 W Leistung 60 s mit UV-Licht bestrahlt. Die UV-Lichtintensität an der Schichtoberfläche betrug 5 mW/cm² bei 365 nm. Nach der Bestrahlung wurde die Beschichtung mit einer Lösung von
1,08 Gew.-% Natriummetasilikat x 9 H₂O,
0,06 Gew.-% Natriumdihydrogenphosphat und
0,68 Gew.-% Trinatriumphosphat x 12 H₂O
in vollentsalztem Wasser entwickelt. Die entwickelte Platte wurde mit Wasser abgespült und ergab eine feine, gleichmäßige Reliefstruktur mit einer kleinsten Linienbreite von 2 µm.

### Beispiel 6

Zur Herstellung einer Photoresistlösung wurden 1 Gew.-teil des Hydroxypolyimids aus Beispiel 2, 0,5 Gew.-teile des in Beispiel 5 angegebenen Naphthochinondiazids und 0,08 Gew.-teile roter Farbstoff (Disperse Red 179) in 10 Gew.-teilen N-Methylpyrrolidon und 10 Gew.-teilen Propylenglykolmonomethylether gelöst. Die Lösung wurde filtriert und dann durch Walzenbeschichtung auf eine anodisierte Aluminiumplatte aufgebracht. Nach 30 Minuten Trocknen der beschichteten Platte bei 90° C erhielt man eine 2 - 3 µm dicke Resistschicht. Diese Schicht wurde mit einer Photomaske abgedeckt. Dann wurde mit einer Quecksilberdampflampe von 200 W Leistung 60 s mit UV-Licht bestrahlt. Die UV-Lichtintensität an der Schichtoberfläche betrug 5 mW/cm² bei 365 nm. Anschließend wurde der Photoresist mit dem in Beispiel 5 angegebenen Entwickler entwickelt und mit Wasser abgespült, so daß sich eine Reliefstruktur mit einer kleinsten Linienbreite von 2 µm ergab.

### Beispiel 7

Zur Herstellung einer Photoresistlösung wurden 10 Gew.-teile des Hydroxypolyimids aus Beispiel 3, 0,5 Gew.-teile des in Beispiel 5 angegebenen Naphthochinondiazids und 0,08 Gew.-teile roter Farbstoff in 10 Gew.-teilen N-Methylpyrrolidon und 10 Gew.-teilen Propylenglykolmonomethylether gelöst. Die Lösung wurde filtriert und dann durch Walzenbeschichtung auf eine anodisierte Aluminiumplatte aufgebracht. Nach 30 Minuten Trocknen bei 90° C erhielt man eine 2 - 3 µm dicke Resistschicht. Diese Schicht wurde mit einer Photomaske abgedeckt. Dann wurde mit einer Quecksilberdampflampe von 200 W Leistung 60 s mit UV-Licht bestrahlt. Die UV-Lichtintensität an der Schichtoberfläche betrug 5 mW/cm² bei 365 nm. Nach der Bestrahlung wurde die Beschichtung mit dem in Beispiel 5 angegebenen Entwickler entwickelt. Die entwickelte Platte wurde mit Wasser abgespült und ergabe eine feine, gleichmäßige Reliefstruktur mit einer geringsten Linienbreite von 2 µm.

### Beispiel 8

Zur Herstellung einer Photoresistlösung wurden 10 Gew.-teile des Hydroxycopolyimids aus Beispiel 4, 0,5 Gew.-teile des in Beispiel 5 angegebenen Naphthochinondiazids und 0,08 Gew.-teile roter Farbstoff in 10 Gew.-teilen N-Methylpyrrolidon und 10 Gew.teilen Propylenglykolmonomethylether gelöst. Die Lösung wurde filtriert und dann durch Walzenbeschichtung auf eine anodisierte Aluminiumplatte aufgebracht. Nach 30 Minuten Trocknen bei 90° C erhielt man eine 2 - 3 µm dicke Resistschicht. Diese Schicht wurde mit einer Photomaske mit Linienstruktur abgedeckt. Dann wurde mit einer Quecksilberdampflampe von 200 W Leistung 60 s mit UV-Licht bestrahlt. Die UV-Lichtintensität an der Schichtoberfläche betrug 5 mW/cm² bei 365 nm. Nach der Bestrahlung wurde die Beschichtung mit einer Lösung von
2,7 Gew.-% Natriummetasilikat x 9 H₂O,
0,15 Gew.-% Natriumdihydrogenphosphat und
1,7 Gew.-% Trinatriumphosphat x 12 H₂O
in vollentsalztem Wasser entwickelt. Die entwickelte Platte wurde mit Wasser abgespült und ergab eine feine, gleichmäßige Reliefstruktur mit einer geringsten Linienbreite von 2 µm.

Die folgenden Beispiele wurden durchgeführt, um die gegenüber Photoresists auf der Basis von Polyamidcarbonsäuren als Vorstufen von Polyimiden verbesserten, mit den erfindungsgemäßen Hydroxypolyimiden erhaltenen positiven Photoresistgemische näher zu kennzeichnen.

Es wurden Photoresistgemische aus den erfindungsgemäßen Polyimiden bereitet, die im wesentlichen gemäß den Beispielen 1 - 4 hergestellt worden waren.

Die Lichtempfindlichkeit jedes Resistgemisches wurde nach dem unten beschriebenen allgemeinen Verfahren ermittelt. Die Trocknungszeit, die Aufschleudergeschwindigkeit und andere Versuchsbedingungen und -ergebnisse für jeden Versuch sind unten angegeben. Die Photoresistlösung wurde mit einer konstanten, vorgegebenen Schleudergeschwindigkeit zwischen 500 und 1.500 Umdrehungen je Minute (Upm) auf Siliciumwafer aufgeschleudert. Das Lösemittel wurde dann durch 30 - 45 Minuten Trocknen vertrieben. Die Schichtdicken der Resistschichten wurden mit einem Rudolf-Schichtdickenmeßgerät gemessen. Zur Bestimmung der Lichtempfindlichkeit wurde eine Kontrastkurve erstellt, wie es in C.G. Willson: "Introduction to Microlithography", Kapitel 3, S. 105, American Chemical Society, Washington, (1983) beschrieben ist. Der Schichtdickenverlust nach 1 Minute Entwickeln wurde über den Logarithmus (1n) der UV-Belichtungsdosis aufgetragen. Die Schichtdicke wurde durch Laser-Interferenzmessungen ermittelt. Der Resist wurde dann mit einem wäßrig-alkalischen Entwickler bei 25 ± 5° C entwickelt. Durch Extrapolieren der Kurve auf den gesamten Schichtdickenverlust erhält man den Wert für die Lichtempfindlichkeit (mJ/cm²).

Bei diesen Versuchen wurden die folgenden strahlungsempfindlichen Verbindungen eingesetzt, die mit folgenden Abkürzungen bezeichnet sind:
a) Z-2000 = ein Trihydroxybenzophenon-1,2-Naphthochinon-2-diazid-5-sulfonsäure-Estergemisch
b) TOOL = 1,2-Naphthochinon-2-diazid-5-sulfonsäuretrisester von Trihydroxyoctanophenon

### Beispiel 9

Zur Herstellung einer Photoresistlösung wurden 13 Gew.-teile des Polyimids aus Beispiel 1 und 13 Gew.-teile Z-2000 in 74 Gew.-teilen eines Lösemittelgemischs gelöst, das zu gleichen Gew.-teilen aus Propylenglykolmonomethylether und N-Methylpyrrolidon bestand. Diese Lösung wurde auf den Wafer aufgeschleudert, getrocknet und mit der in Beispiel 5 angegebenen Lichtquelle belichtet. Der Entwickler bestand aus einer Lösung von
0,8 Gew.-% Natriummetasilikat x 9 H₂O,
0,04 Gew.-% Natriumdihydrogenphosphat und
0,5 Gew.-% Trinatriumphosphat x 12 H₂O
in vollentsalztem Wasser. Es wurden folgende Ergebnisse erhalten:

| | |
|---|---|
| Lichtempfindlichkeit: | 97 mJ/cm² |
| Abtragsrate: | 15 nm/min |
| Kontrast: | 1,5 |

### Beispiel 10

Zur Herstellung einer Photoresistlösung wurden 13 Gew.-teile des Polyimids aus Beispiel 2 und 13 Gew.-teile Z-2000 in 74 Gew.-teilen des in Beispiel 9 angegebenen Lösemittelgemischs gelöst. Diese Lösung wurde auf den Wafer aufgeschleudert, getrocknet und mit der in Beispiel 5 angegebenen Lichtquelle belichtet. Der Entwickler bestand aus einer Lösung von
0,6 Gew.-% Natriummetasilikat x 9 H₂O,
0,03 Gew.-% Natriumdihydrogenphosphat und
0,4 Gew.-% Trinatriumphosphat x 12 H₂O
in vollentsalztem Wasser. Es wurden folgende Ergebnisse erhalten:

| | |
|---|---|
| Lichtempfindlichkeit: | 82 mJ/cm² |
| Abtragsrate: | 20 nm/min |
| Kontrast: | 1,3 |

### Beispiel 11

Zur Herstellung einer Photoresistlösung wurden 13 Gew.-teile des Polyimids aus Beispiel 3 und 13 Gew.-teile Z-2000 in 74 Gew.-teilen des in Beispiel 9 angegebenen Lösemittelgemischs gelöst. Diese Lösung wurde auf den Wafer aufgeschleudert, getrocknet und mit der in Beispiel 5 angegebenen Lichtquelle belichtet. Der Entwickler bestand aus einer Lösung von
0,5 Gew.-% Natriummetasilikat x 9 H₂O,
0,03 Gew.-% Natriumdihydrogenphosphat und
0,3 Gew.-% Trinatriumphosphat x 12 H₂O
in vollentsalztem Wasser. Es wurden folgende Ergebnisse erhalten:

| | |
|---|---|
| Lichtempfindlichkeit: | 96 mJ/cm² |
| Abtragsrate: | 22 nm/min |
| Kontrast: | 1,42 |

### Beispiel 12

Zur Herstellung einer Photoresistlösung wurden 13 Gew.-teile des Copolyimids aus Beispiel 4 und 13 Gew.-teile Z-2000 in 74 Gew.-teilen des in Beispiel 9 angegebenen Lösemittelgemischs gelöst. Diese Lösung wurde auf den Wafer aufgeschleudert, getrocknet und mit der in Beispiel 5 angegebenen Lichtquelle belichtet. Der Entwickler bestand aus einer Lösung von
1,8 Gew.-% Natriummetasilikat x 9 H₂O,
0,1 Gew.-% Natriumdihydrogenphosphat und
1,1 Gew.-% Trinatriumphosphat x 12 H₂O
in vollentsalztem Wasser. Es wurden folgende Ergebnisse erhalten:

| | |
|---|---|
| Lichtempfindlichkeit: | 242 mJ/cm² |
| Abtragsrate: | 16 nm/min |
| Kontrast: | 1,6 |

## Patentansprüche

1. Polyimid mit wiederkehrenden Einheiten der allgemeinen Formel I 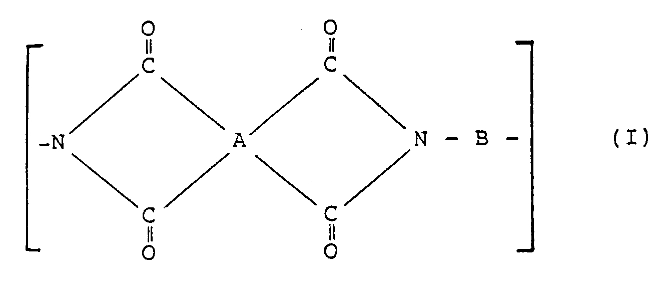 enthält, worin
A der Rest einer Verbindung mit mindestens einem aromatischen Sechsring ist, wobei jede der vier Carbonylgruppen an ein anderes aromatisches Kohlenstoffatom von A gebunden ist und wobei jeweils zwei Carbonylgruppen an benachbarten Kohlenstoffatomen stehen, und
B der Rest einer Verbindung mit mindestens einem aromatischen Sechsring und mindestens einer Hydroxygruppe ist, mit der Maßgabe,
daß entweder der Rest A der Formel IIIa 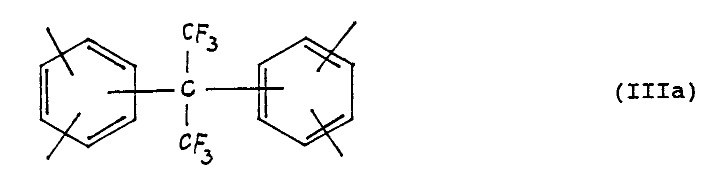 oder der Rest B der Formel IVa 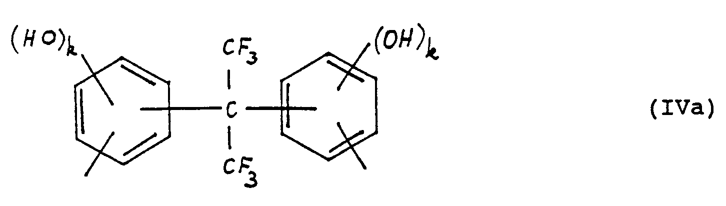 worin k für eine ganze Zahl von O bis 3 steht,
oder daß der Rest A der Formel IIIa und der Rest B der Formel IVa entspricht.

2. Polyimid nach Anspruch 1, dadurch gekennzeichnet, daß es neben Einheiten der allgemeinen Formel I bis zu 80 mol-% Einheiten der allgemeinen Formel II 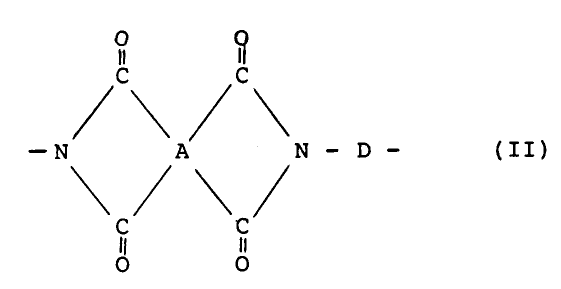 bezogen auf die Summe der Einheiten I und II enthält, wobei
D ein von Hydroxygruppen freier aromatischer Rest mit mindestens einem aromatischen Sechsring
ist und A die in Anspruch 1 angegebene Bedeutung hat.

3. Polyimid nach Anspruch 1, dadurch gekennzeichnet, daß A mindestens zwei aromatische Sechsringe enthält.

4. Polyimid nach Anspruch 1, dadurch gekennzeichnet, daß B mindestens zwei aromatische Sechsringe enthält.

5. Polyimid nach Anspruch 1, dadurch gekennzeichnet, daß A ein Rest der Formel III 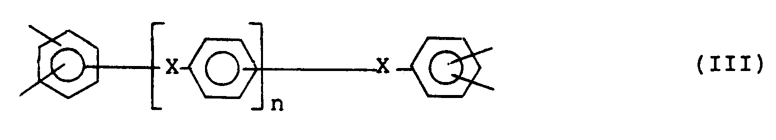 ist, worin
X eine Einfachbindung, O, CO, SO₂, eine Alkylengruppe oder eine fluorierte Alkylengruppe mit 1 bis 6 Kohlenstoffatomen und
n 0, 1 oder 2 ist.

6. Polyimid nach Anspruch 1, dadurch gekennzeichnet, daß B ein Rest der Formel IV 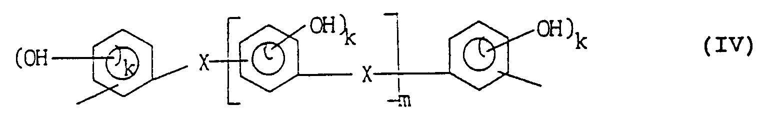 ist, worin
X eine Einfachbindung, O, CO, SO₂, eine Alkylengruppe oder eine fluorierte Alkylengruppe mit 1 bis 6 Kohlenstoffatomen,
m eine Zahl von 0 bis 4 und
k für jeden Benzolring unabhängig eine Zahl von 0 bis 3 ist,
wobei der Rest B insgesamt mindestens eine OH-Gruppe enthält.

7. Polyimid nach Anspruch 2, dadurch gekennzeichnet, daß D ein Rest der Formel V 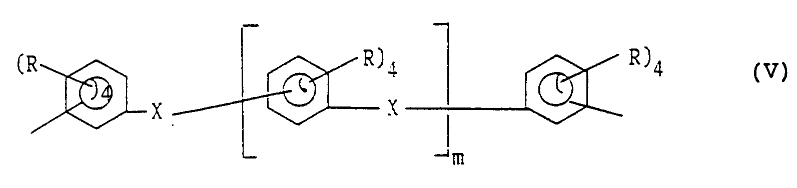 ist, worin
X eine Einfachbindung, O, CO, SO₂, eine Alkylengruppe oder eine fluorierte Alkylengruppe mit 1 bis 6 Kohlenstoffatomen,
R für jeden Fall unabhängig ein Wasserstoff- oder Halogenatom, eine Alkyl- oder Alkoxygruppe mit 1 bis 6 Kohlenstoffatomen oder eine Acylgruppe mit 2 bis 10 Kohlenstoffatomen und
m eine Zahl von 0 bis 4 ist.

8. Photoresistgemisch, das als wesentliche Bestandteile eine lichtempfindliche Verbindung und ein Polyimid enthält, dadurch gekennzeichnet, daß das Polyimid eine Verbindung gemäß einem der Ansprüche 1 bis 7 ist.

## Claims

1. Polyimide having recurring units of the general formula I 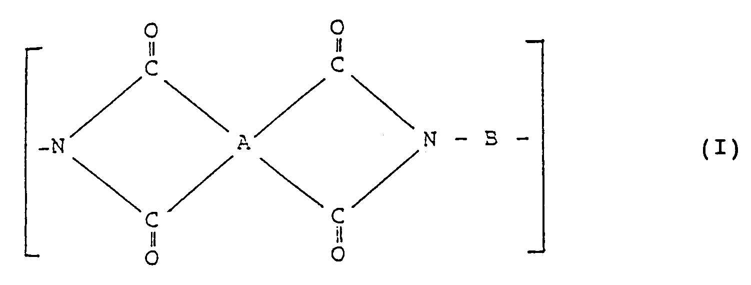 where
A is the radical of a compound having at least one aromatic six ring, each of the four carbonyl groups being attached to a different aromatic carbon atom of A and each pair of carbonyl groups being situated on adjacent carbon atoms, and
B is the radical of a compound having at least one aromatic six ring and at least one hydroxyl group,
with the proviso that either the radical A conforms to the formula IIIa 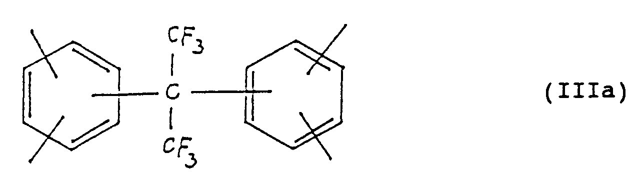 or the radical B to the formula IVa 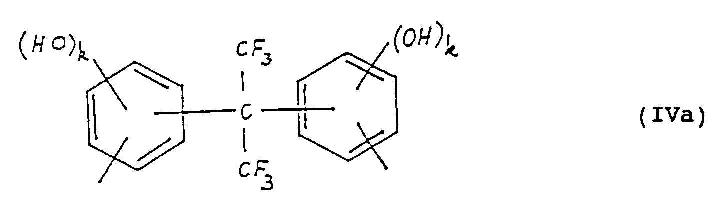 where k is an integer from 0 to 3, or that the radical A conforms to the formula IIIa and the radical B to the formula IVa.

2. Polyimide according to Claim 1, characterised in that in addition to units of the general formula I it contains up to 80 mol% of units of the general formula II 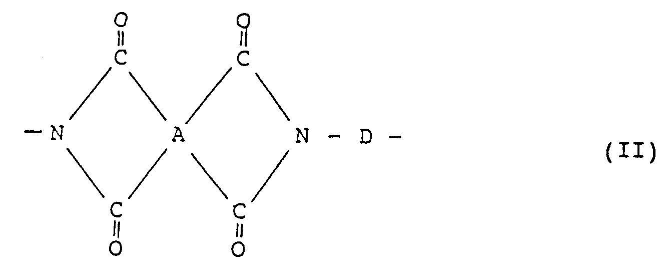 based on the sum total of units I and II, wherein
D is a hydroxyl-devoid aromatic radical having at least one aromatic six ring and A is as defined in Claim 1.

3. Polyimide according to Claim 1, characterised in that A contains at least two aromatic six rings.

4. Polyimide according to Claim 1, characterised in that B contains at least two aromatic six rings.

5. Polyimide according to Claim 1, characterised in that A is a radical of the formula III 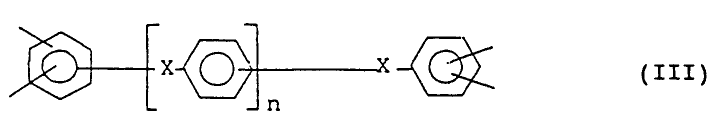 where
X is a single bond, O, CO, SO₂, an alkylene group or a fluorinated alkylene group having 1 to 6 carbon atoms, and
n is 0, 1 or 2.

6. Polyimide according to Claim 1, characterised in that B is a radical of the formula IV 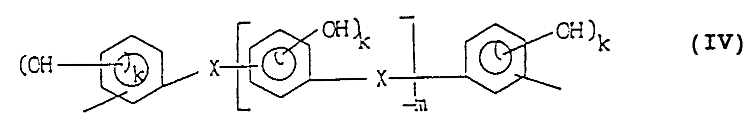 where
X is a single bond, O, CO, SO₂, an alkylene group or a fluorinated alkylene group having 1 to 6 carbon atoms,
m is from 0 to 4, and
k is a number independently selected from 0 to 3 for each benzene ring,
the radical B containing in total at least one OH group.

7. Polyimide according to Claim 2, characterised in that D is a radical of the formula V 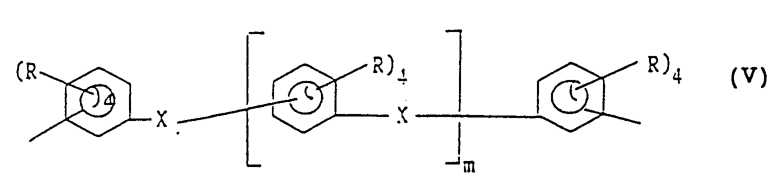 where
X is a single bond O, CO, SO₂, an alkylene group or a fluorinated alkylene group having 1 to 6 carbon atoms,
R is in each case independently selected from hydrogen, halogen, alkyl or alkoxy having 1 to 6 carbon atoms and acyl having 2 to 10 carbon atoms, and
m is from 0 to 4.

8. Photoresist mixture containing as essential constituents a light-sensitive compound and a polyimide, characterised in that the polyimide is a compound according to any one of Claims 1 to 7.

## Revendications

1. Polyimide à motifs répétitifs de formule générale I 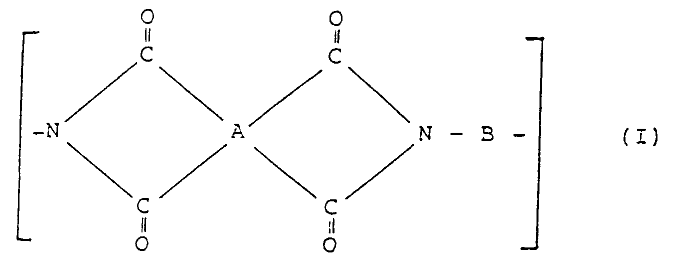 dans laquelle
A est le reste d'un composé comportant au moins un cycle hexagonal aromatique, chacun des quatre groupes carbonyle étant lié à un atome de carbone aromatique de A différent et deux groupes carbonyle de chaque paire se trouvant sur des atomes de carbone voisins, et
B est le reste d'un composé comportant au moins un cycle hexagonal aromatique et au moins un groupe hydroxy,
étant entendu que soit le reste A correspond à la formule IIIa 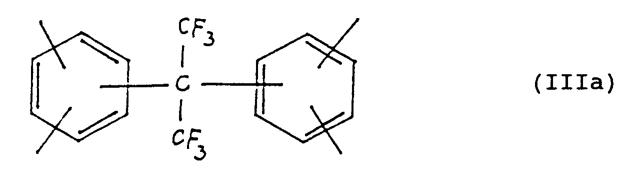 soit le reste B correspond à la formule IVa 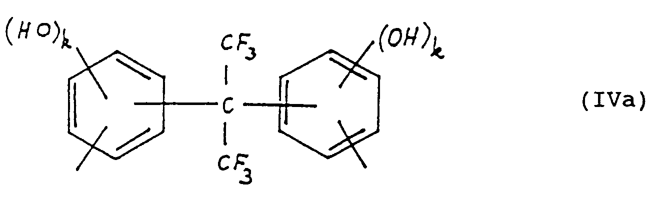 dans laquelle k représente un nombre entier allant de 0 à 3, ou que le reste A correspond à la formule IIIa et le reste B correspond à la formule IV a.

2. Polyimide selon la revendication 1, caractérisé en ce qu'il contient, en plus de motifs de formule générale I, jusqu'à 80 % en moles de motifs de formule générale II 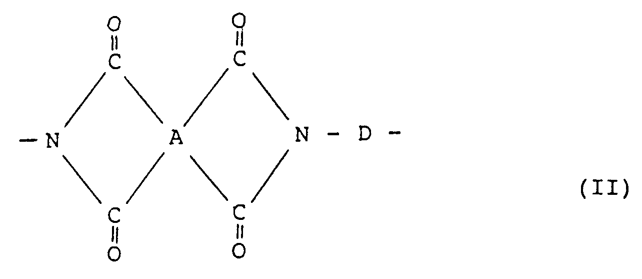 par rapport à la somme des motifs I et II,
D étant un radical aromatique comportant au moins un cycle hexagonal aromatique et exempt de groupes hydroxy, et
A ayant la signification donnée dans la revendication 1.

3. Polyimide selon la revendication 1, caractérisé en ce que A contient au moins deux cycles hexagonaux aromatiques.

4. Polyimide selon la revendication 1, caractérisé en ce que B contient au moins deux cycles hexagonaux aromatiques.

5. Polyimide selon la revendication 1, caractérisé en ce que A est un reste de formule III 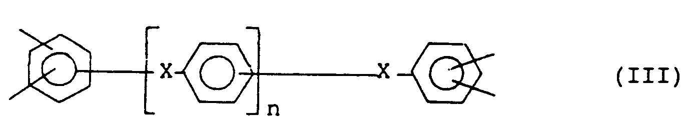 dans laquelle
X est une simple liaison, O, CO, SO₂, un groupe alkylène ou un groupe alkylène fluoré ayant de 1 à 6 atomes de carbone, et
n est 0, 1 ou 2.

6. Polyimide selon la revendication 1, caractérisé en ce que B est un reste de formule IV 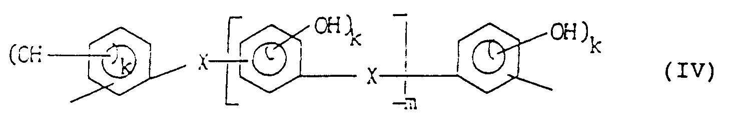 dans laquelle
X est une simple liaison, O, CO, SO₂, un groupe alkylène ou un groupe alkylène fluoré ayant de 1 à 6 atomes de carbone,
m est un nombre entier allant de 0 à 4, et
k est, indépendamment pour chaque cycle benzénique, un nombre allant de 0 à 3,
le reste B contenant au total au moins un groupe OH.

7. Polyimide selon la revendication 2, caractérisé en ce que D est un reste de formule V 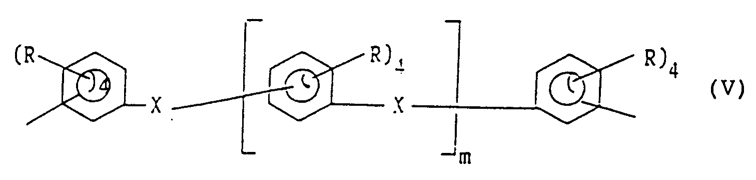 dans laquelle
X est une simple liaison, O, CO, SO₂, un groupe alkylène ou un groupe alkylène fluoré ayant de 1 à 6 atomes de carbone,
R est, indépendamment pour chaque cas, un atome d'hydrogène ou d'halogène, un groupe alkyle ou alcoxy ayant de 1 à 6 atomes de carbone ou un groupe acyle ayant de 2 à 10 atomes de carbone, et
m est un nombre allant de 0 à 4.

8. Composition de photorésist contenant, en tant que composants essentiels, un composé photosensible et un polyimide, caractérisée en ce que le polyimide est un composé selon l'une des revendications 1 à 7.
